# EUROPEAN PATENT APPLICATION

(11) **EP 4 672 871 A1**
(43) Date of publication of application: **31.12.2025**
(21) Application number: 25151057.4
(22) Date of filing: 09.01.2025
(51) Int. Cl.: H05K 1/14, H05K 3/36, H05K 1/18, H05K 3/28

(54) **CIRCUIT BOARD ASSEMBLY AND ELECTRONIC DEVICE**

(30) Priority: 28.06.2024 CN 202410870743
(71) Applicant: Beijing Xiaomi Mobile Software Co., Ltd., Beijing 100085 (CN)
(72) Inventor: QU, Xiaodong, Beijing (CN)
(74) Representative: Dehns Germany Partnerschaft mbB

(57) **Abstract**

A circuit board assembly (100) and an electronic device are provided. The circuit board assembly (100) includes a first circuit board (1), a first transfer board (2), a second transfer board (3), and a second circuit board (4). The second transfer board (3) is arranged between a top of the first transfer board (2) and a bottom of the second circuit board (4). The first circuit board (1) is stacked with the second circuit board (4) in a thickness direction of the circuit board assembly (100) sequentially through the first transfer board (2) and the second transfer board (3).

## Description

### TECHNICAL FIELD

The present invention relates to the field of integrated circuit technology, in particular, to a circuit board assembly and an electronic device.

### BACKGROUND

With the development of the electronic device industry, the functions required for devices such as mobile phones are gradually increasing, and the electronic components required to achieve these functions are also increasing. Therefore, higher requirements have been put forward for the area a circuit board assembly occupies.

The circuit board assembly, at present, in order to achieve more functions, occupies too much area, resulting in an inappropriate spatial layout of the circuit board assembly, which affects the entire size of the electronic device and ultimately affects the user experience.

### SUMMARY

The present invention provides a circuit board assembly and an electronic device, which can provide a more appropriate spatial layout, improved space utilization, and a reduced size.

The present invention provides a circuit board assembly, including: a first circuit board, a first transfer board, a second transfer board, and a second circuit board, wherein the second transfer board is arranged between a top of the first transfer board and a bottom of the second circuit board, and the first circuit board is stacked with the second circuit board in a thickness direction of the circuit board assembly sequentially through the first transfer board and the second transfer board.

Optionally, the first transfer board and the second transfer board are staggered in the thickness direction of the circuit board assembly.

Optionally, a first cavity is formed through enclosing by the first transfer board and the first circuit board, a second cavity is formed through enclosing by the first transfer board, the first circuit board, the second transfer board, and the second circuit board, a top of the first circuit board and the bottom of the second circuit board are both provided with multiple electronic components, and the multiple electronic components are respectively located in the first cavity and the second cavity.

Optionally, the first transfer board includes at least one groove, an opening of the groove is arranged towards the first circuit board, the first cavity is formed through enclosing by the groove and a portion of the top of the first circuit board, and some of the multiple electronic components located on the top of the first circuit board are accommodated within the first cavity.

Optionally, a first gap is presented between a bottom of the groove and top surfaces of the electronic components located on the top of the first circuit board in the first cavity.

Optionally, a second gap is presented between a side wall of the groove and side surfaces of the electronic components located on the top of the first circuit board in the first cavity.

Optionally, the second transfer board is arranged between the top of the first transfer board and the bottom of the second circuit board, the second transfer board includes an transfer through-hole, the first transfer board includes at least one through-hole, the through-hole is communicated with the transfer through-hole, and the second cavity is formed through enclosing by the bottom of the second circuit board, a side wall of the through-hole, a side wall of the transfer through-hole, and a portion of the top of the first circuit board, and wherein some of the multiple electronic components located on the top of the first circuit board and the multiple electronic components located at the bottom of the second circuit board are both accommodated within the second cavity.

Optionally, the transfer through-hole of each second transfer board is communicated with each of the at least one through-hole of the first transfer board in correspondence.

Optionally, a shape of the transfer through-hole and a shape of the through-hole are fit to each other, and preferably, the shape of the transfer through-hole and the shape of the through-hole are both irregular hexagons.

Optionally, the number of second transfer boards is at least one, and the at least one second transfer board is arranged on the top of the first transfer board.

Optionally, the number of second circuit boards is at least one, and the at least one second circuit board is arranged on a top of the second transfer board.

Optionally, there is a first gap between top surfaces of the electronic components located on the top of the first circuit board in the second cavity and bottom surfaces of the electronic components located at the bottom of the second circuit board in the second cavity.

Optionally, there is a second gap between a side wall of the through-hole and side surfaces of the electronic components located on the top of the first circuit board in the second cavity.

Optionally, there is a third gap between a side wall of the transfer through-hole and side surfaces of the electronic components located at the bottom of the second circuit board in the second cavity.

Optionally, the circuit board assembly further includes multiple shielding covers.

Optionally, the top of the first transfer board is provided with multiple first electronic components, and the shielding covers are arranged on the top of the first transfer board to cover the multiple first electronic components located on the top of the first transfer board.

Optionally, the top of the second circuit board is provided with multiple second electronic components, and the shielding covers are arranged on the top of the second circuit board to cover the multiple second electronic components located on the top of the second circuit board.

Optionally, the top of the first circuit board is provided with multiple first electronic components, and the shielding covers are arranged on the top of the first circuit board to cover some of the multiple first electronic components located on the top of the first circuit board.

Optionally, the bottom of the first circuit board is provided with multiple second electronic components, and the shielding covers are arranged at the bottom of the first circuit board to cover the multiple second electronic components located at the bottom of the first circuit board.

Optionally, the first transfer board includes a cavity circuit board.

Optionally, the first circuit board includes a main circuit board.

Optionally, the second circuit board includes a radio frequency circuit board.

Optionally, a gap distance of the gap is set based on friction and heat dissipation requirements of the electronic components.

The present invention also provides an electronic device including the circuit board assembly as described in any of the above.

According to the circuit board assembly and the electronic device provided in the present invention, the circuit board assembly can be easy to be assembled and have a simple structure by placing the second transfer board between the top of the first transfer board and the bottom of the second circuit board. The first transfer board and the second transfer board are partially stacked in the thickness direction of the circuit board assembly, so that the space utilization of the circuit board assembly in the thickness and the horizontal directions can be improved, and the spatial layout of the circuit board assembly can be made more appropriate, thereby reducing the overall size of the circuit board assembly, and enhancing the user experience.

### BRIEF DESCRIPTION OF THE DRAWINGS

The drawings, which are incorporated into and constitute a part of the specification, illustrate embodiments consistent with the present invention and serve together with the specification to explain the principles of the present invention.
FIG. 1 shows a schematic diagram of a circuit board assembly according to one or more embodiments of the present invention.
FIG. 2 shows a cross-sectional view of the circuit board assembly according to embodiments of FIG. 1.

Explanations of reference numerals:
circuit board assembly 100; first circuit board 1; first transfer board 2; groove 21; through hole 22; second transfer board 3; transfer through hole 31; second circuit board 4; first cavity 5; second cavity 6; electronic component 7; shielding cover 8.

### DETAILED DESCRIPTION

Exemplary embodiments will be described in detail here, with examples shown in the drawings. When referring to the drawings, unless otherwise indicated, the same numbers in different drawings represent the same or similar elements. The implementations described in the following exemplary embodiments do not represent all implementations consistent with the present invention. On the contrary, the implementations are only examples of devices consistent with some aspects of the present invention as described in the appended claims.

The terms used in the present disclosure are for the purpose of describing specific embodiments only and are not intended to limit the scope of the present invention. Unless otherwise defined, the technical or scientific terms used in the present disclosure shall have the usual meanings understood by those skilled of general skill in the art to which the present invention belongs. The use of similar words such as "one" or "a" in the specification and the claims of the present disclosure does not imply a quantity limitation, but rather indicates the existence of at least one. The term "multiple" includes two, equivalent to at least two. The terms such as "include" or "comprise" refer to elements or objects that appear before "include" or "comprise", include those listed after "include" or "comprise" and their equivalents, and do not exclude other elements or objects. The terms such as "connect" or "couple" are not limited to physical or mechanical connections, and can include electrical connections, whether direct or indirect. The singular forms of "a", "said", and "the" used in the specification and the appended claims are also intended to include the majority forms, unless the context clearly indicates otherwise. It should also be understood that the term "and/or" used in the present disclosure refers to and includes any or all possible combinations of one or more associated items listed.

The circuit board assembly according to the present invention includes a first circuit board, a first transfer board, a second transfer board, and a second circuit board. The second transfer board is arranged between a top of the first transfer board and a bottom of the second circuit board. The first circuit board is stacked with the second circuit board in a thickness direction of the circuit board assembly sequentially through the first transfer board and the second transfer board. The circuit board assembly can be easy to be assembled and have a simple structure by placing the second transfer board between the top of the first transfer board and the bottom of the second circuit board. The first transfer board and the second transfer board are partially stacked in the thickness direction of the circuit board assembly, so that the space utilization of the circuit board assembly in the thickness and the horizontal directions can be improved, and the spatial layout of the circuit board assembly can be made more appropriate, thereby reducing the overall size of the circuit board assembly, and enhancing the user experience.

The present invention provides a circuit board assembly and an electronic device. The circuit board assembly and the electronic devices of the present invention will be described in detail with reference to the drawings. In the absence of conflict, the features in the following embodiments and implementations can be combined with each other.

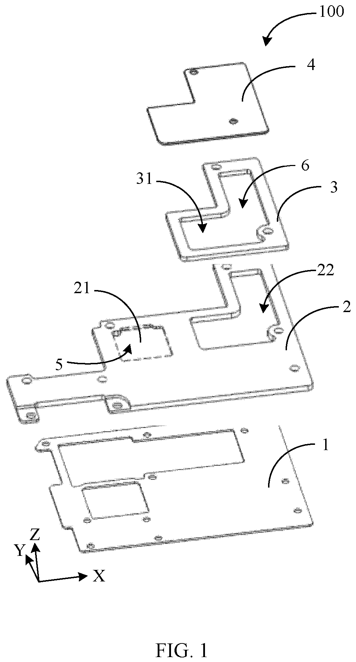

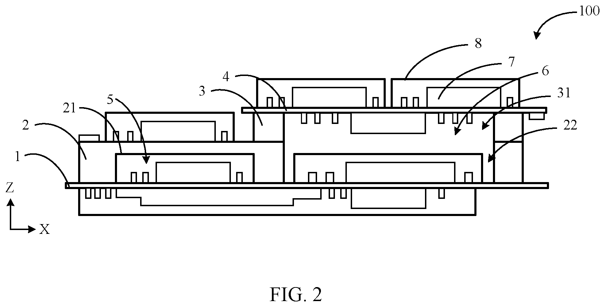

FIG. 1 shows a schematic diagram of a circuit board assembly 100 according to one or more embodiments of the present invention. FIG. 2 shows a cross-sectional view of the circuit board assembly 100 according to embodiments of FIG. 1.

In embodiments shown in FIGS. 1 and 2, the electronic device includes a circuit board assembly 100. The electronic device can be commonly used devices such as mobile phones and tablets. The circuit board assembly 100 includes a first circuit board 1, a first transfer board 2, a second transfer board 3, and a second circuit board 4 stacked in sequence from bottom to top. In some embodiments, the first circuit board 1 (baseband, referred to as BB board) includes a main circuit board. The main circuit board can be a printed circuit board (referred to as PCB board). The first transfer board 2 includes a cavity circuit board, which can be a cavity PCB. The second transfer board 3 can be an interposer board (referred to as an int board). The second circuit board 4 includes a radio frequency (RF) circuit board, which can be an RF PCB (referred to as RF board). The RF PCB is a printed circuit board specifically used for RF circuit design and manufacturing. The first circuit board 1, the first transfer board 2, and the second circuit board 4 are used to arrange an electronic component 7, and the second transfer board 3 is used to increase the space in the thickness direction (Z direction) and the horizontal plane direction (X and Y directions) of the entire circuit board assembly 100. The circuit board assembly 100 includes a first circuit board 1, a first transfer board 2, a second transfer board 3, and a second circuit board 4. The second transfer board 3 is arranged between the top of the first transfer board 2 and the bottom of the second circuit board 4. The first circuit board 1 is stacked with the second circuit board 4 in the thickness direction of the circuit board assembly 100 sequentially through the first transfer board 2 and the second transfer board 3. The circuit board assembly 100 can be easy to be assembled and have a simple structure by placing the second transfer board 3 between the top of the first transfer board 2 and the bottom of the second circuit board 4. The first transfer board 2 and the second transfer board 3 are partially stacked in the thickness direction of the circuit board assembly 100, so that the space utilization of the circuit board assembly 100 in the thickness and the horizontal directions can be improved, and the spatial layout of the circuit board assembly 100 can be made more appropriate, thereby reducing the overall size of the circuit board assembly 100, making the structure of the electronic device lighter and thinner, and enhancing the user experience. In some embodiments, the second transfer board 3 does not include a portion that is directly connected to the first circuit board 1 and the second circuit board 4, thereby reducing the size in the horizontal plane direction (X and Y directions), and reducing the number of soldering times in the production of the circuit board assembly. For the circuit board assembly not designed in this way, the size of the circuit board assembly 100 in the thickness direction (Z direction) and the horizontal plane direction (X and Y directions) of the circuit board assembly 100 will be increased, thereby increasing the volume of the circuit board assembly 100 and increasing the space for installing the circuit board assembly 100 in the electronic device, resulting in space waste.

In embodiments shown in FIGS. 1 and 2, the first transfer board 2 and the second transfer board 3 are partially stacked in the thickness direction of the circuit board assembly 100, and projection planes of the first transfer board 2 and the second transfer board 3 on the first circuit board 1 are partially overlapped. The circuit board assembly 100 is formed by stacking the first circuit board 1, the first transfer board 2, the second transfer board 3, and the second circuit board 4 in sequence from bottom to top. The first transfer board 2 and the second transfer board 3 are partially stacked in the thickness direction of the circuit board assembly 100, so that the space utilization of the circuit board assembly 100 in the thickness direction can be improved. In addition, the projection surfaces of the first transfer board 2 and the second transfer board 3 on the first circuit board 1 are partially overlapped, so that the space utilization of the circuit board assembly 100 in the horizontal plane direction can be improved, and the spatial layout of the circuit board assembly 100 can be made more appropriate, thereby reducing the overall size of the circuit board assembly 100, and enhancing the user experience. The first transfer board 2 and the second transfer board 3 are staggered in the thickness direction of the circuit board assembly 100. In some embodiments, the first transfer board 2 and the second transfer board 3 are staggered in the thickness direction of the circuit board assembly, so that a portion of the first transfer board 2 can overlap with the second transfer board 3 in the thickness direction of the circuit board assembly 100, and a portion of the first transfer board 2 is exposed to the outside. As a result, the first transfer board 2 can have more space to accommodate the electronic component 7, making the spatial layout of the circuit board assembly 100 more appropriate and improving the space utilization efficiency of the circuit board assembly 100.

In embodiments shown in FIGS. 1 and 2, the first transfer board 2 includes at least one groove 21 and at least one through-hole 22. A first cavity 5 is formed through enclosing by the at least one groove 21 and the first circuit board 1. The first cavity 5 is used to accommodate multiple electronic components 7 of the circuit board assembly 100. A second cavity 6 is formed through enclosing by the at least one through-hole 22, the first circuit board 1, the second transfer board 3, and the second circuit board 4. The second chamber 6 is used to accommodate multiple electronic components 7 of the circuit board assembly 100. The top of the first circuit board 1 and the bottom of the second circuit board 4 are both provided with multiple electronic components 7. The electronic components 7 are used to implement the functions required by the electronic device corresponding to circuit board assembly 100. The multiple electronic components 7 are located in the first cavity 5 and the second cavity 6, respectively.

The circuit board assembly 100 is formed by stacking the first circuit board 1, the first transfer board 2, the second transfer board 3, and the second circuit board 4 in sequence from bottom to top. The first cavity 5 is formed through enclosing by the at least one groove 21 of the first transfer board 2 and the first circuit board 1, and the second cavity 6 is formed through enclosing by the at least one through-hole 22, the first circuit board 1, the second transfer board 3, and the second circuit board 4. By effectively utilizing the through-hole 22 and the groove 21 of the first transfer board 2, the multiple electronic components 7 can be accommodated in the first cavity 5 and the second cavity 6, the space utilization can be improved and the stacking height of the multiple layers of circuit boards can be reduced, thereby reducing the thickness of the circuit board assembly 100, ultimately reducing the thickness of the overall electronic device, and enhancing the user experience. In some embodiments, the first transfer board 2 and the sandwich-stacked board (i.e., the sandwich-stacked board formed by the second circuit board 4, the second transfer board 3, and the first circuit board 1) are used to form the three-dimensional stacking process with more layers than the sandwich-stacking, which enables the placement of electronic components 7 on all five surfaces of the circuit board assembly 100. The size of the circuit board assembly 100 can be reduced in the X direction, and the placement area can be increased in the Z direction, meeting the layout of the electronic components 7 and meeting the requirements of extreme stacking and the electronic device. For example, in mobile phones, a large camera module decoration (referred to as deco) are usually needed.

In embodiments shown in FIGS. 1 and 2, the opening of the groove 21 is oriented towards the first circuit board 1 (the dashed line in FIG. 1 represents that the groove 21 is arranged on a side facing the first circuit board 1), and the first cavity 5 is formed by enclosing by the groove 21 and a portion of the top surface of the first circuit board 1. The electronic components 7 located on the top of the first circuit board 1 are accommodated in the first cavity 5. Some electronic components 7 on the top of the first circuit board 1 are accommodated in the first cavity 5, ensuring the functionality of the electronic device. The space of the circuit board assembly 100 in the Z direction is utilized, and the space of the circuit board assembly 100 in the X and Y directions is saved. There is a gap between top surfaces of the electronic components 7 located on the top of the first circuit board 1 in the first cavity 5 and the bottom of the groove 21. In this way, the electronic component 7 can be protected while ensuring that there is no friction between the top surface of the electronic component 7 and the bottom of the groove 21, thereby preventing interference with the functionality of the electronic component 7. The gap distance between the top surface of the electronic component 7 located on the top of the first circuit board 1 and the bottom of the groove 21 can be set according to actual needs, as long as it can meet the heat dissipation requirements of the electronic component 7. There is a gap between side surfaces of the electronic components 7 located on the top of the first circuit board 1 in the first cavity 5 and the side wall of the groove 21. In this way, the electronic component 7 can be protected while ensuring that there is no friction between the side surface of the electronic component 7 and the side wall of the groove 21, thereby preventing interference with the functionality of the electronic component 7. The gap distance between the side surface of the electronic component 7 located on the top of the first circuit board 1 and the side wall of the groove 21 can be set according to actual needs, as long as it can meet the heat dissipation requirements of the electronic component 7.

In embodiments shown in FIGS. 1 and 2, the second transfer board 3 is arranged between the top of the first transfer board 2 and the bottom of the second circuit board 4. The second transfer board 3 is used to increase the height between the first transfer board 2 and the second circuit board 4. The second transfer board 3 includes a transfer through-hole 31. The transfer through-hole 31 is used to save space of the circuit board assembly 100. The through-hole 22 is communicated with the transfer through-hole 31, forming a second cavity through enclosing by a portion of the top surface of the first circuit board 1, the bottom surface of the second circuit board 4, the side wall of the through-hole 22, and the side wall of the transfer through-hole 31. In some embodiments, the through-hole 22 is communicated with the transfer through-hole 31 and forms the second cavity 6 with the inner side surface of the second transfer board 3, a portion of the top surface of the first circuit board 1, and the bottom surface of the second circuit board 4, respectively. In some embodiments, the shape of the through-hole 22 and the shape of the transfer through-hole 31 are fit to each other, and both are irregular hexagons extending in the X and Y directions. In this way, the space of the second cavity 6 can be increased. The number of the second transfer boards 3 is at least one. In some embodiments, the number of the second transfer boards 3 can be one, two, three, etc., but the number is not limited to this. The at least one second transfer board 3 is arranged on the top of the first transfer board 2. In some embodiments, multiple second transfer boards 3 are distributed on the top of the first transfer board 2 in the X and/or Y directions. In this way, the space of the circuit board assembly 100 in the X and Y directions can be increased, making it easier to arrange more electronic components 7. The transfer through-hole 31 of each second transfer board 3 is communicated with each through-hole 22 of the first transfer board 2 in correspondence. In this way, the space of the circuit board assembly 100 in the Z direction can be increased, making it easier to arrange more electronic components 7 in the Z direction. In some embodiments, the transfer through-hole 31 of each second transfer board 3 can be not communicated with each through-hole 22 of the first transfer board 2 in correspondence, or the transfer through-hole 31 of each second transfer board 3 can also be directly arranged on the top of the second circuit board 4, which is not limited to this. The number of the second circuit boards 4 is at least one. In some embodiments, the number of the second circuit boards 4 can be one, two, three, etc., but the number is not limited to this. The at least one second circuit board 4 is located on the top of the second transfer board 3. The at least one second circuit board 4 is arranged in correspondence with each second transfer board 3. In this way, the number of the second circuit boards 4 can be increased, thereby increasing more positions for more electronic components 7 to be installed. In some embodiments, each second circuit board 4 is arranged in correspondence with each through-hole 22 of the first transfer board 2. In this way, the number of sides where the second circuit boards 4 faces towards the second transfer board 3 can be increased, making it easier to install more electronic components 7.

In embodiments shown in FIGS. 1 and 2, a portion of the electronic components 7 located on the top of the first circuit board 1 and the multiple electronic components 7 located at the bottom of the second circuit board 4 are both accommodated in the second cavity 6. In this way, the second cavity 6 can accommodate some electronic components 7 of the first circuit board 1 and some electronic components 7 of the second circuit board 4, thereby utilizing the space of the circuit board assembly 100 in the Z direction and saving the space of the circuit board assembly 100 in the X and Y directions. There is a gap between top surfaces of the electronic components 7 located on the top of the first circuit board 1 in the second cavity 6 and bottom surfaces of the electronic components 7 located at the bottom of the second circuit board 4 in the second cavity 6. In this way, the electronic component 7 can be protected while ensuring that there is no friction between the top surface of the electronic component 7 located on the top of the first circuit board 1 in the second cavity 6 and the bottom surface of the electronic component 7 located at the bottom of the second circuit board 4 in the second cavity 6, thereby preventing interference with the functionality of the electronic component 7. The gap distance between the top surface of the electronic component 7 located on the top of the first circuit board 1 in the second cavity 6 and the bottom surface of the electronic component 7 located at the bottom of the second circuit board 4 in the second cavity 6 can be set according to actual needs, as long as it can meet the heat dissipation requirements of the electronic component 7. There is a gap between side surfaces of the electronic components 7 located on the top of the first circuit board 1 in the second cavity 6 and the side wall of the through-hole 22. In this way, the electronic component 7 can be protected while ensuring that there is no friction between the side surface of the electronic component 7 and the side wall of the through-hole 22, thereby preventing interference with the functionality of the electronic component 7. The gap distance between the side surface of the electronic component 7 located on the top of the first circuit board 1 in the second cavity 6 and the side wall of the through-hole 22 can be set according to actual needs, as long as it can meet the heat dissipation requirements of the electronic component 7. There is a gap between side surfaces of the electronic components 7 located at the bottom of the second circuit board 4 in the second cavity 6 and the side wall of the transfer through-hole 31. In this way, the electronic component 7 can be protected while ensuring that there is no friction between the side surface of the electronic component 7 and the side wall of the transfer through-hole 31, thereby preventing interference with the functionality of the electronic component 7.

In embodiments shown in FIG. 2, the circuit board assembly 100 further includes multiple shielding covers 8. The shielding covers 8 are used to protect the electronic components 7, prevent signal interference, and effectively improve the circuit performance of circuit board assembly 100. The top of the first transfer board 2 is provided with multiple electronic components 7. The shielding covers 8 are arranged on the top of the first transfer board 2, covering the multiple electronic components 7 located on the top of the first transfer board 2. The shielding covers 8 shield the multiple electronic components 7 on the top of the first transfer board 2. In some embodiments, the multiple electronic components 7 on the top of the first transfer board 2 are located on the top surface of the outer surface of the groove 21 of the first transfer board 2, that is, the multiple electronic components 7 on the top of the first transfer board 2 are located at the part of the top of the first transfer board 2 that is not covered by the second transfer board 3 and the second circuit board 4. The top of the first circuit board 1 is provided with multiple electronic components 7, and the shielding cover 8 is arranged on the top of the first circuit board 1, covering some of the electronic components 7 located on the top of the first circuit board 1. In some embodiments, the shielding covers 8 shield the electronic components 7 located on the first transfer board 2 in the second cavity 6. The electronic components 7 in the first cavity 5 are covered by the groove 21 of the first transfer board 2, and the shielding cover 8 may not be provided or may be provided, but is not limited to this. The bottom of the first circuit board 1 is provided with multiple electronic components 7, and the shielding cover 8 is arranged at the bottom of the first circuit board 1, covering the multiple electronic components 7 located at the bottom of the first circuit board 1. The electronic components 7 at the bottom of the first circuit board 1 are exposed to the outside. In some embodiments, one shielding cover 8 can be provided. In some embodiments, multiple shielding covers 8 can also be provided, but is not limited to this. The top of the second circuit board 4 is provided with multiple electronic components 7, and the shielding cover 8 is arranged on the top of the second circuit board 4, covering the multiple electronic components 7 located on the top of the second circuit board 4. The electronic components 7 on the top of the second circuit board 4 are exposed to the outside. In some embodiments, two shielding covers 8 are provided, and also one shielding cover 8, three shielding covers 8, four shielding covers 8, etc. can be provided, but is not limited to this. The electronic components 7 at the bottom of the second circuit board 4 and some electronic components 7 on the top of the first circuit board 1 are arranged in the second cavity 6. In some embodiments, some of the electronic components 7 on the top of the first circuit board 1 may be provided with the shielding cover 8, while the electronic components 7 at the bottom of the second circuit board 4 may not be provided with the shielding cover 8. In some embodiments, some of the electronic components 7 on the first circuit board 1 may not be provided with the shielding cover 8, while the electronic components 7 at the bottom of the second circuit board 4 may be provided with the shielding cover 8. In some embodiments, some of the electronic components 7 on the first circuit board 1 and the electronic components 7 at the bottom of the second circuit board 4 may both be provided with shielding covers 8, but is not limited to this.

The above are only preferred embodiments of the present invention and are not intended to limit the present invention. The scope of the invention is defined by the claims.

## Claims

1. A circuit board assembly (100), comprising a first circuit board (1), a first transfer board (2), a second transfer board (3), and a second circuit board (4), wherein the second transfer board (3) is arranged between a top of the first transfer board (2) and a bottom of the second circuit board (4), and the first circuit board (1) is stacked with the second circuit board (4) in a thickness direction of the circuit board assembly (100) sequentially through the first transfer board (2) and the second transfer board (3).

2. The circuit board assembly (100) according to claim 1, wherein the first transfer board (2) and the second transfer board (3) are staggered in the thickness direction of the circuit board assembly (100).

3. The circuit board assembly (100) according to claim 1 or 2, wherein a first cavity (5) is formed through enclosing by the first transfer board (2) and the first circuit board (1), a second cavity (6) is formed through enclosing by the first transfer board (2), the first circuit board (1), the second transfer board (3), and the second circuit board (4), a top of the first circuit board (1) and the bottom of the second circuit board (4) are both provided with multiple electronic components (7), and the multiple electronic components (7) are respectively located in the first cavity (5) and the second cavity (6).

4. The circuit board assembly (100) according to claim 3, wherein the first transfer board (2) comprises at least one groove (21), an opening of the groove (21) is arranged towards the first circuit board (1), the first cavity (5) is formed through enclosing by the groove (21) and a portion of the top of the first circuit board (1), and some of the multiple electronic components (7) located on the top of the first circuit board (1) are accommodated within the first cavity (5).

5. The circuit board assembly (100) according to claim 3 or 4, wherein a first gap is presented between a bottom of the groove (21) and top surfaces of the electronic components (7) located on the top of the first circuit board (1) in the first cavity (5); and/or
a second gap is presented between a side wall of the groove (21) and side surfaces of the electronic components (7) located on the top of the first circuit board (1) in the first cavity (5).

6. The circuit board assembly (100) according to claim 3, wherein the second transfer board (3) comprises an transfer through-hole (31), the first transfer board (2) comprises at least one through-hole (22), the through-hole (22) is communicated with the transfer through-hole (31), and the second cavity (6) is formed through enclosing by the bottom of the second circuit board (4), a side wall of the through-hole (22), a side wall of the transfer through-hole (31), and a portion of the top of the first circuit board (1), and wherein some of the multiple electronic components (7) located on the top of the first circuit board (1) and the multiple electronic components (7) located at the bottom of the second circuit board (4) are both accommodated within the second cavity (6).

7. The circuit board assembly (100) according to claim 6, wherein the transfer through-hole (31) of each second transfer board (3) is communicated with each of the at least one through-hole (22) of the first transfer board (2) in correspondence.

8. The circuit board assembly (100) according to claim 6 or 7, wherein a shape of the transfer through-hole (31) and a shape of the through-hole (22) are fit to each other, and preferably, the shape of the transfer through-hole (31) and the shape of the through-hole (22) are both irregular hexagons.

9. The circuit board assembly (100) according to any of claims 6 to 8, wherein
at least one second transfer board (3) is comprised, and the at least one second transfer board (3) is arranged on the top of the first transfer board (2); and/or
at least one second circuit board (4) is comprised, and the at least one second circuit board (4) is arranged on a top of the second transfer board (3).

10. The circuit board assembly (100) according to any of claims 6 to 9, wherein a first gap is presented between top surfaces of the electronic components (7) located on the top of the first circuit board (1) in the second cavity (6) and bottom surfaces of the electronic components (7) located at the bottom of the second circuit board (4) in the second cavity (6); and/or
a second gap is presented between a side wall of the through-hole (22) and side surfaces of the electronic components (7) located on the top of the first circuit board (1) in the second cavity (6); and/or
a third gap is presented between a side wall of the transfer through-hole (31) and side surfaces of the electronic components (7) located at the bottom of the second circuit board (4) in the second cavity (6).

11. The circuit board assembly (100) according to any of claims 1 to 10, further comprising multiple shielding covers (8), wherein
the top of the first transfer board (2) is provided with multiple first electronic components (7), and the shielding covers (8) are arranged on the top of the first transfer board (2) to cover the multiple first electronic components (7) located on the top of the first transfer board (2); and/or
a top of the second circuit board (4) is provided with multiple second electronic components (7), and the shielding covers (8) are arranged on the top of the second circuit board (4) to cover the multiple second electronic components (7) located on the top of the second circuit board (4).

12. The circuit board assembly (100) according to any of claims 1 to 10, further comprising multiple shielding covers (8), wherein
a top of the first circuit board (1) is provided with multiple first electronic components (7), and the shielding covers (8) are arranged on the top of the first circuit board (1) to cover some of the first electronic components (7) located on the top of the first circuit board (1); and/or
a bottom of the first circuit board (1) is provided with multiple second electronic components (7), and the shielding covers (8) are arranged at the bottom of the first circuit board (1) to cover the multiple second electronic components (7) located at the bottom of the first circuit board (1).

13. The circuit board assembly (100) according to any of claims 1 to 12, wherein the first transfer board (2) comprises a cavity circuit board; and/or
the first circuit board (1) comprises a main circuit board; and/or
the second circuit board (4) comprises a radio frequency circuit board.

14. The circuit board assembly (100) according to claim 5 or 10, wherein a gap distance of the gap is set based on friction and heat dissipation requirements of the electronic components (7).

15. An electronic device comprising the circuit board assembly (100) according to any of claims 1 to 14.
